# EUROPEAN PATENT SPECIFICATION

(11) **EP 3 503 217 B1**
(45) Date of publication and mention of the grant of the patent: **11.05.2022**
(21) Application number: 17843160.7
(22) Date of filing: 09.06.2017
(51) Int. Cl.: H01L 31/068, H01L 31/0747

(54) **SOLAR CELL AND SOLAR CELL MODULE**
SOLARZELLE UND SOLARZELLENMODUL
CELLULE SOLAIRE ET MODULE DE CELLULE SOLAIRE

(30) Priority: 22.08.2016 JP 2016161825
(43) Date of publication of application: 26.06.2019
(73) Proprietor: Kaneka Corporation, Osaka-shi, Osaka 530-8288 (JP)
(72) Inventor: YOSHIKAWA, Kunta, Settsu-shi Osaka 566-0072 (JP); KAWASAKI, Hayato, Settsu-shi Osaka 566-0072 (JP); YOSHIDA, Wataru, Settsu-shi Osaka 566-0072 (JP)
(74) Representative: V.O.
(86) International application number: PCT/JP2017/021546
(87) International publication number: WO 2018/037672

(56) References cited:
- WO-A1-2012/018119
- FR-A1- 3 026 229
- JP-A- 2013 219 185
- JP-A- 2014 053 330
- JP-A- 2015 532 543
- US-A1- 2013 220 414
- US-A1- 2014 102 531

## Description

### TECHNICAL FIELD

The invention relates to a solar cell and solar cell module.

### BACKGROUND ART

A general solar cell is a double-sided electrode type solar cell, which includes an electrode on both a light-receiving surface and a back surface. On the other hand, a back contact solar cell having an electrode only on a back surface is free from a shading loss caused by an electrode on a light-receiving surface, and thus excellent in light utilization efficiency, and therefore can attain high conversion efficiency.

In the back contact solar cell, p-type regions and n-type regions patterned in a predetermined shape are arranged on the back side of a semiconductor substrate, and electrodes are disposed on these conductivity-type regions. The pattern shape of the conductivity-type region in the back contact solar cell generally has a configuration in which p-type regions and n-type regions extending in one direction are alternately arranged along a direction perpendicular to the extending direction.

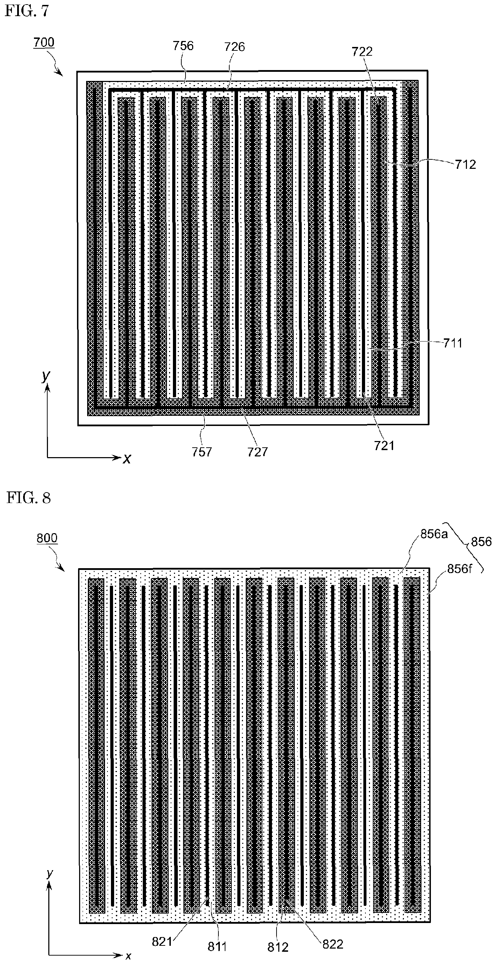

For example, Patent Document 1 discloses a back contact solar cell in which a first conductivity-type region and a second conductivity-type region are patterned in an interdigitated comb teeth shape (see FIG. 7). The first conductivity-type region and the second conductivity-type region are provided with a first conductivity-type semiconductor layer and a second conductivity-type semiconductor layer, respectively. The first conductivity-type semiconductor layer and the second conductivity-type semiconductor layer have mutually different conductivity-types. One of the semiconductor layers is a p-type semiconductor layer, and the other is an n-type semiconductor layer. In this form, first conductivity-type regions 711 and second conductivity-type regions 712 extending in a y direction are alternately arranged in an x direction. A metal electrode (finger electrode) 721 extending in a y direction is disposed on the first conductivity-type region 711, and a metal electrode (finger electrode) 722 extending in a y direction is disposed on the second conductivity-type region 712.

At one end of the back surface of a solar cell in a y direction, a first conductivity-type region 756 extending in an x direction is arranged so as to connect a plurality of first conductivity-type regions 711. The first conductivity-type region 756 extending in an x direction is also referred to as a "bus bar region". A metal electrode (bus bar electrode) 726 is disposed on the bus bar region 756. The bus bar electrode 726 connects finger electrodes 721 disposed, respectively, on a plurality of first conductivity-type regions 711. At the other end of the back surface of the solar cell, a second conductivity-type region 757 extending in an x direction is arranged to connect a plurality of second conductivity-type regions 712 as a bus bar region. On the bus bar region, a bus bar electrode 727 is provided, which connects finger electrodes 722 disposed, respectively, on a plurality of second conductivity-type regions 712.

Bus bar electrodes 726 and 727 disposed, respectively, on bus bar regions 756 and 757 connect a plurality of finger electrodes, and serve to gather carriers collected by the finger electrodes and establish electrical connection to other solar cells. In modularization performed by connecting a plurality of solar cells, an interconnector is mounted onto the bus bar electrode to establish electrical connection between adjacent solar cells.

The back contact solar cell has no electrode on the light-receiving surface, so that the light receiving amount on a semiconductor substrate is maximized to improve conversion efficiency. For improving the conversion efficiency of the back contact solar cell, it is important to effectively collect photocarriers produced at the end portion (peripheral edge) of the semiconductor substrate, as well as photocarriers produced at the central portion of the semiconductor substrate. Patent Document 1 suggests that by covering the peripheral edge of a semiconductor substrate with an amorphous semiconductor layer, carrier recombination at an exposed portion of the semiconductor substrate can be reduced to improve conversion efficiency.

Patent Document 2 discloses a back contact solar cell in which first conductivity-type regions 811 and second conductivity-type regions 812 extending in a y direction are alternately arranged in an x direction, and a bus bar region is not provided (see FIG. 8). In the solar cell, finger electrodes 821 disposed, respectively, on a plurality of first conductivity-type regions 811 are separated from one another, and finger electrodes 822 disposed, respectively, on a plurality of second conductivity-type regions 812 are separated from one another. Patent Document 2 suggests that a specific wiring sheet is used for connection between a plurality of finger electrodes 821, connection between a plurality of finger electrodes 822, and electrical connection between adjacent solar cells.

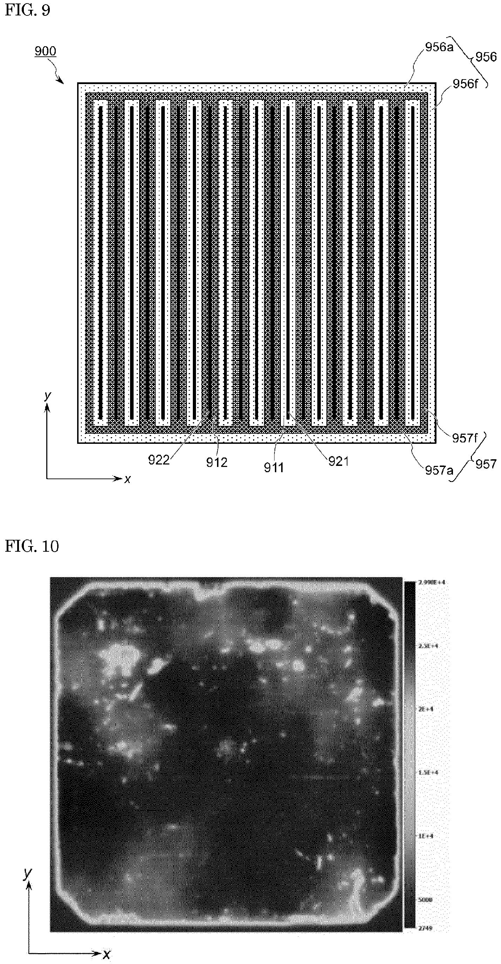

Patent Document 3 discloses a form having an outer peripheral region arranged so as to surround the outer peripheral portion of a semiconductor substrate as a pattern shape of a semiconductor layer in a back contact solar cell (see FIG. 9). Specifically, an outer peripheral second conductivity-type region 957 including a region 957a extending in an x direction and a region 957f extending in a y direction, and an outer peripheral first conductivity-type region 956 including a region 956a extending in an x direction and a region 956f extending in a y direction are provided. The outer peripheral second conductivity-type region 957 surrounds a plurality of first conductivity-type regions 951 and second conductivity-type regions 952 alternately arranged in an x direction. The outer peripheral first conductivity-type region 956 surrounds the outer peripheral second conductivity-type region 957. Patent Document 3 suggests that when electrodes are not disposed on these outer peripheral conductivity-type regions, collection efficiency of photocarriers produced at the end portion of the semiconductor substrate can be improved, leading to improvement of conversion efficiency.

Patent Document 4 discloses a solar cell having an integrated bypass switch. A patterned first level metal is positioned on the layer backside. A trench isolation pattern partitions the semiconductor layer into a solar cell region and a monolithically integrated bypass switch region. The solar cell region contains alternating band-shaped first and second conductivity-type regions that extend along a first direction. The monolithically integrated bypass switch region contains first and second conductivity-type regions around the solar cell region.

Patent Document 5 discloses an improvement of photoelectric conversion efficiency of a solar cell with p-type and n-type semiconductor regions on the back surface. The p type regions form a single comb shape electrode, with finger portions extending from a bus bar. The n type regions are divided into a succession of separate comb shape electrodes, with fingers portions that are interdigitated with those of the p type comb shape. The single comb formed by the p type regions includes fingers between the successive combs formed by the n type regions. The tips of these fingers extend between the bus bars of the successive combs. This improves the photoelectric conversion efficiency because it reduces the distance that holes, which are minority carriers in the solar cell substrate, must be moved before being collected.

### PRIOR ART DOCUMENTS

### PATENT DOCUMENTS

Patent Document 1: WO 2012/018119
Patent Document 2: Japanese Patent Laid-open Publication No. 2010-157553
Patent Document 3: Japanese Patent Laid-open Publication No. 2013-219185
Patent Document 4: US Patent Application No 2014-102531
Patent Document 5: Japanese Patent Laid open No 2014-053330

### SUMMARY OF THE INVENTION

### PROBLEMS TO BE SOLVED BY THE INVENTION

Recombination of photoinduced carriers easily occurs at the end portion of a semiconductor substrate. When the entire substrate surface including the peripheral edge of a principal surface of the substrate and a lateral surface of the substrate is covered with an amorphous semiconductor layer, etc., recombination can be reduced, but even in this case, carrier recombination more easily occurs at the end portion of the substrate than at
the central portion. Thus, for improving the conversion efficiency of the back contact solar cell, it is important to suppress carrier recombination at the end portion of the substrate, so that photoinduced carriers are effectively collected.

In view of the above-mentioned problems, an object of the present invention is to provide a back contact solar cell having a small collection loss caused by carrier recombination in the vicinity of the end portion of a semiconductor substrate, and having high conversion efficiency.

### MEANS FOR SOLVING THE PROBLEMS

A solar cell according to claim 1 is provided.

As described above, in a back contact solar cell, band-shape first conductivity-type regions and band-shape second conductivity-type regions extending in one direction are alternately arranged on the entire back surface of a substrate or most regions of the back surface of the substrate except end portions. The present inventors have found that a back contact solar cell with a conductivity-type region having such an in-plane pattern has an anisotropy in carrier lifetime in the vicinity of the end portion of a substrate.

To be more specific, the back contact solar cell tends to have a shorter carrier lifetime and more easily undergoes carrier recombination at the end portion in an extending direction of the conductivity-type region than at the end portion in a direction perpendicular to the conductivity-type region. In a solar cell of the present invention, a conductivity-type region has a predetermined pattern shape at the end portion in an extending direction of the conductivity-type region, so that carrier recombination at the end portion of a semiconductor substrate can be suppressed.

The solar cell of the present invention is defined by the subject-matter of claim 1.

In one embodiment of the back contact solar cell, an intrinsic semiconductor layer, a first conductivity-type semiconductor layer and a transparent electroconductive layer are disposed in this order on the second principal surface of the semiconductor substrate in the first conductivity-type region, and an intrinsic semiconductor layer, a second conductivity-type semiconductor layer and a transparent electroconductive layer are disposed in this order on the second principal surface of the semiconductor substrate in the second conductivity-type region.

The present invention also relates to a solar cell module in which a plurality of the solar cells are connected through a wiring member.

### EFFECTS OF THE INVENTION

In a solar cell of the present invention, band-shape first conductivity-type regions and second conductivity-type regions each extending in a second direction are alternately arranged in a first direction end portion region. Thus, photocarriers produced at the central portion are inhibited from moving to the end portion of the semiconductor substrate in the first direction, so that the carrier recombination amount can be reduced to improve the efficiency of the solar cell.

### BRIEF DESCRIPTION OF THE DRAWINGS

FIG. 1 is a plan view of a back contact solar cell not part of the present invention.
FIG. 2 is a sectional view taken along line A1-A2 in FIG. 1.
FIG. 3 is a plan view of a back contact solar cell not part of the present invention.
FIG. 4 is a plan view of a back contact solar cell according to one embodiment according to the present invention.
FIG. 5 is a plan view of a back contact solar cell according to one embodiment according to the present invention.
FIG. 6 is a plan view of a back contact solar cell not part of the present invention.
FIG. 7 is a plan view of a conventional back contact solar cell.
FIG. 8 is a plan view of a conventional back contact solar cell.
FIG. 9 is a plan view of a conventional back contact solar cell.
FIG. 10 is a photoluminescence (PL) image of the conventional back contact solar cell in an open state.
FIG. 11 is a plan view of a solar cell .
FIG. 12A is a conceptual view for illustrating the movement of carriers produced at the central portion to the end portion in the solar cell.
FIG. 12B is a conceptual view for illustrating the movement of carriers produced at the central portion to the end portion in the solar cell.
FIG. 13 is a plan view of a back contact solar cell according to one embodiment according to the present invention.
FIG. 14A shows one example of a cross-section along the extending direction of the first wiring member for the back contact solar cell in FIG. 13.
FIG. 14B shows one example of a cross-section along the extending direction of the first wiring member for the back contact solar cell in FIG. 13.

### MODE FOR CARRYING OUT THE INVENTION

### (Configuration of Back Contact Solar Cell)

A solar cell of the present invention includes a rectangular-shaped semiconductor substrate and having a first principal surface and a second principal surface, the second principal surface being provided with a first conductivity-type region and a second conductivity-type region which are patterned in a predetermined shape. The first principal surface of the semiconductor substrate is a light-receiving surface, and the second principal surface is a back surface at the time when the solar cell generates power.

The first conductivity-type region is provided with a first conductivity-type semiconductor layer, and the second conductivity-type region is provided with a second conductivity-type semiconductor layer. The first conductivity-type semiconductor layer and the second conductivity-type semiconductor layer are semiconductor layers having different conductivity-types. One of the semiconductor layers is a p-type semiconductor layer, and the other is an n-type semiconductor layer. In this specification, the conductivity-type of a semiconductor layer included in a conductivity-type region arranged at the end of the semiconductor substrate in a first direction (y direction) is referred to as a first conductivity-type. In other words, the conductivity-type region arranged at the peripheral edge of the end in the first direction is the first conductivity-type region. The first conductivity-type region may be referred to as a peripheral edge first conductivity-type region.

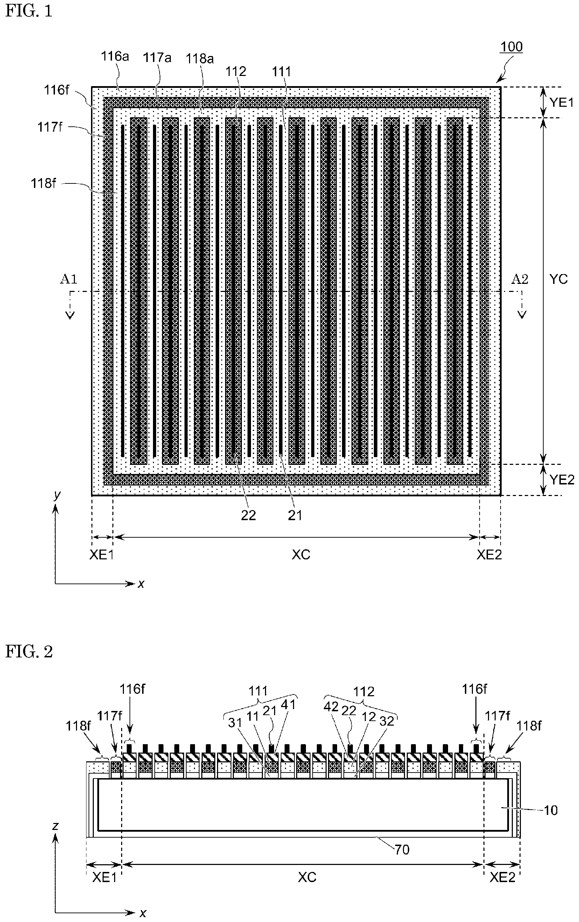

FIG. 1 is a plan view of a back contact solar cell not part of the present invention on the second principal surface (back surface) side. FIG. 2 is a sectional view taken along line A1-A2 in FIG. 1.

As shown in FIG. 1, a solar cell 100 has first conductivity-type regions 111, 116a, 116f, 118a and 118f and second conductivity-type regions 112, 117a and 117f on the back surface (upper surface in FIG. 2) of a semiconductor substrate 10.

The semiconductor substrate 10 has a rectangular shape in plan view. The rectangular shape is not required to be a perfectly square shape or oblong shape, and for example, the semiconductor substrate may have a semi-square shape (a rectangular shape having rounded corners or having a notched portion).

The example not part of the present invention shown in FIG. 2 is a so-called heterojunction silicon solar cell, in which a crystalline silicon substrate or the like is used as the semiconductor substrate 10. The crystalline silicon substrate may be either a single-crystalline silicon substrate or a polycrystalline silicon substrate.

The conductivity-type of the silicon substrate may be either an n-type or a p-type. It is preferable to use an n-type single-crystalline silicon substrate from the viewpoint of the length of carrier lifetime in the silicon substrate. The thickness of the silicon substrate is, for example, about 50 to 300 µm. Preferably, a texture (irregularity structure) is provided on the light-receiving surface (first principal surface) of the silicon substrate from the viewpoint of optical confinement. A texture may also be provided on the back surface (second principal surface) of the silicon substrate.

As shown in FIG. 2, a first conductivity-type semiconductor layer 11 is disposed on the second principal surface of the semiconductor substrate 10 in the first conductivity-type region 111. A second conductivity-type semiconductor layer 12 is disposed on the second principal surface of the semiconductor substrate 10 in the second conductivity-type region 112. The first conductivity-type semiconductor layer 11 and the second conductivity-type semiconductor layer 12 are silicon-based thin-films of amorphous silicon, crystalline silicon or the like. Preferably, intrinsic semiconductor layers 31 and 32 are disposed between the silicon substrate 10 and the conductive semiconductor layers 11 and 12. By providing an intrinsic semiconductor layer such as a silicon thin-film on a surface of the silicon substrate, surface defects of the silicon substrate are terminated to increase the carrier lifetime.

Although the method for depositing a silicon-based thin-film is not particularly limited, a plasma-enhanced CVD is preferable. As a material gas for CVD, an SiH₄ gas is preferable. As a dopant addition gas to be used for deposition of the conductive silicon-based thin-film, hydrogen-diluted B₂H₆ or PH₃ is preferable. Impurities such as oxygen and carbon may be added in a very small amount for improving the light transmittance. For example, by introducing gases of CO₂, CH₄ and the like in CVD, oxygen and carbon can be introduced into the silicon-based thin-film.

When a silicon-based thin-film is deposited by a dry process such as a CVD method, it is preferable that a thin-film is disposed so as to cover the end portion and lateral surface of the substrate as shown in FIG. 2. In addition, it is preferable that a passivation layer 70 on the first principal surface is also disposed so as to cover the end portion and lateral surface of the substrate. By providing amorphous silicon or the like so as to cover the end portion and lateral surface of the substrate as described above, carrier recombination at the end portion of the substrate can be suppressed.

Preferably, the first conductivity-type semiconductor layer 11 and the second conductivity-type semiconductor layer 12 are not in contact with each other. In the example shown in FIG. 2, a separation groove is arranged between the first conductivity-type region 111 and the second conductivity-type region 112, and each layer is patterned so as to separate the conductivity-type regions. As shown in Patent Document 1 (WO 2012/018119), a boundary between the first conductivity-type region and the second conductivity-type region may be an overlap region in which both the first conductivity-type semiconductor layer and the second conductivity-type semiconductor layer are disposed. By providing an insulating layer between the first conductivity-type semiconductor layer and the second conductivity-type semiconductor layer in the overlap region, contact between the first conductivity-type semiconductor layer and the second conductivity-type semiconductor layer can be prevented.

The method for patterning the first conductivity-type semiconductor layer 11 and the second conductivity-type semiconductor layer 12 in a predetermined shape is not particularly limited, and examples thereof include a method in which a silicon-based thin-film is formed using a mask, and a method in which a semiconductor layer, etc. under a resist opening is removed using an etchant or an etching paste while the surface is covered with a resist or the like.

The conductive semiconductor layer in the solar cell of the present invention is not limited to the silicon-based thin-film. The conductive semiconductor layer may be, for example, a doping layer disposed on a surface of the silicon substrate. A doping layer can be formed by doping a surface of the silicon substrate with a dopant such as P or B (conductivity-type determination impurity) by thermal diffusion, laser doping or the like.

In a heterojunction solar cell, transparent electroconductive layers 41 and 42 are disposed between conductive semiconductor layers 11 and 12 and metal electrodes 21 and 22, respectively. The material of the transparent electroconductive layer is preferably a conductive oxide such as an indium tin oxide (ITO) or zinc oxide. The transparent electroconductive layer can be formed by a sputtering method, a CVD method or the like. It is preferred the transparent electroconductive layers are patterned, like the conductive semiconductor layers.

The metal electrodes 21 and 22, respectively, disposed on the transparent electroconductive layers 41 and 42 can be formed by a known method such as printing or plating, and an Ag electrode formed by screen printing with an Ag paste, a copper plating electrode formed by electroplating, or the like is preferably used

Among conductivity-type regions of the outer peripheral portion in the solar cell 100 shown in FIG. 1, the first conductivity-type region 118f extending in the y direction is provided with a transparent electroconductive layer and a metal electrode, and other conductivity-type regions of the outer peripheral portion are not provided with an electrode. The pattern of the metal electrode is not limited to the form shown in FIG. 1, and conductivity-type regions 117f and 116f extending in the y direction may be provided with the metal electrode. In addition, conductivity-type regions 118a, 117a and 116a extending in the x direction may be provided with the metal electrode. The metal electrode provided in the first conductivity-type region 118a may be connected to the metal electrode 21 provided in the first conductivity-type region 111.

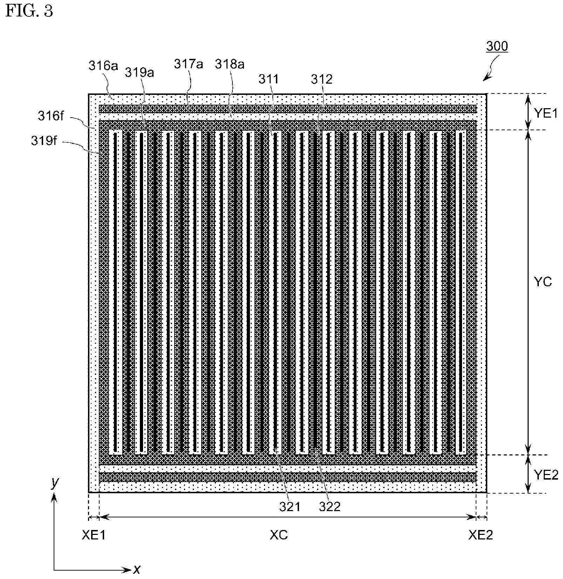

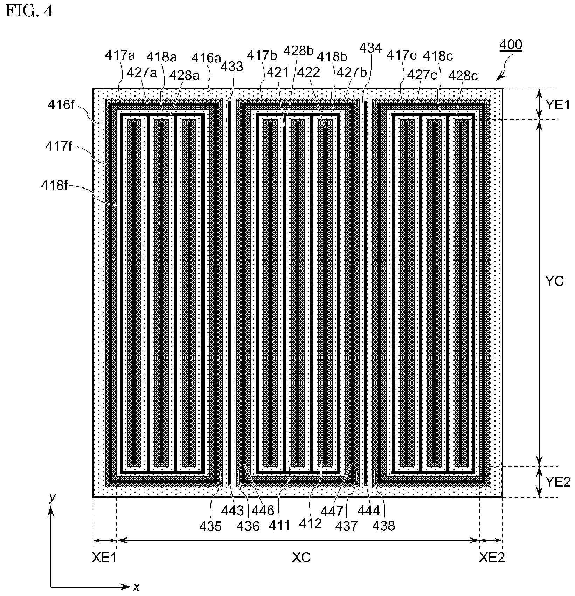

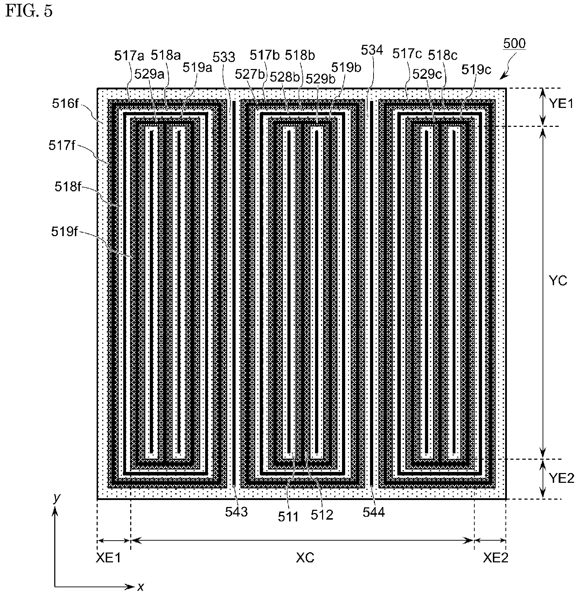

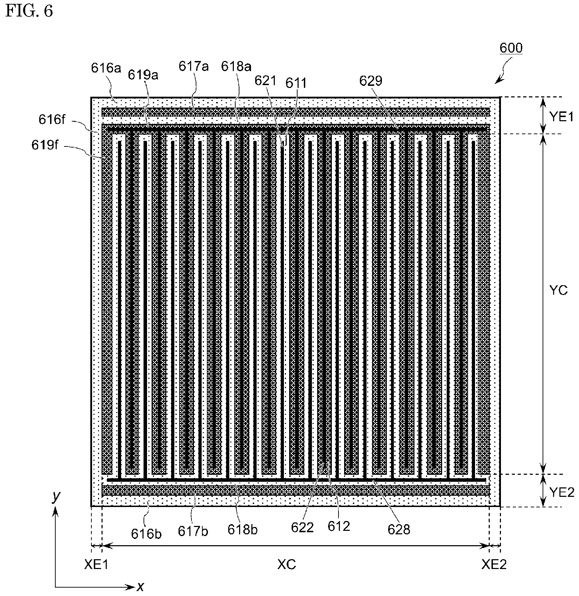

In examples not part of the present invention (FIGS. 3 and 6) and embodiments according to the invention (FIGS. 4 and 5) described later and shown in FIGS. 3, 4, 5 and 6, the metal electrode should be provided on first conductivity-type regions and second conductivity-type regions alternately arranged along the x direction in the central region of the substrate, and the end portion regions may be provided or not provided with the metal electrode. Whether or not the metal electrode is to be provided in end portion regions can be determined in consideration of the carrier collecting efficiency, the width of the conductive layer, the process margin or the like.

In the back contact solar cell, the first principal surface that is a light-receiving surface does not directly contribute to power generation and extraction of currents. Thus, the structure on the first principal surface is not particularly limited as long as reception of sunlight is not inhibited. In the example shown in FIG. 2, the passivation layer 70 is disposed on the first principal surface (lower side in FIG. 2) of the silicon substrate 10.

The passivation layer 70 may be a single layer or a stack of plural layers. When a crystalline silicon substrate is used as the semiconductor substrate, it is preferable that an intrinsic amorphous silicon thin-film is disposed in contact with the first principal surface of the crystalline silicon substrate for enhancing the passivation effect. A conductive semiconductor thin-film may be further disposed on the intrinsic amorphous silicon thin-film.

Preferably, the conductive semiconductor thin-film disposed on the intrinsic silicon thin-film has a conductivity-type identical to that of the semiconductor substrate 10. For example, when the semiconductor substrate 10 is an n-type crystalline silicon substrate, it is preferable that the passivation layer 70 on the first principal surface has a configuration in which an intrinsic amorphous silicon thin-film and an n-type amorphous silicon thin-film are stacked.

An anti-reflection layer (not shown) also serving as a protecting layer may be disposed on the passivation layer 70. The material for the anti-reflection layer is not particularly limited as long as it is capable of protecting the passivation layer present under the anti-reflection layer, and has light-transmittance. The anti-reflection layer is preferably a light-transmitting thin-film having a refractive index of about 1.5 to 2.3, and as a material thereof, SiO, SiN, SiON or the like is used. Although the method for forming the anti-reflection layer is not particularly limited, a CVD method is preferable because the thickness can be precisely controlled.

On the back surface of the semiconductor substrate, first direction end portion regions YE1 and YE2 are present at both end portions in the first direction (y direction), and a first direction central region YC is present between these end portion regions. In the first direction end portion regions YE1 and YE2, a band-shape conductivity-type region is arranged so as to extend in the second direction (x direction). In the example shown in FIG. 1, the first conductivity-type region 116a, the second conductivity-type region 117a and the first conductivity-type region 118a are arranged in this order along the first direction from the end portion of the substrate. As described above, the peripheral edge conductivity-type region arranged at the end portion in the first direction is the first conductivity-type region.

In the first direction central region YC, band-shape first conductivity-type regions and band-shape second conductivity-type regions are arranged so as to extend in the first direction. In the example shown in FIG. 1, first conductivity-type regions 111, 116f and 118f and second conductivity-type regions 112 and 117f are arranged so as to extend in the first direction (y direction). The first conductivity-type region and the second conductivity-type region are alternately arranged along the second direction (x direction). Specifically, the peripheral edge longitudinal first conductivity-type region 116f and the outer peripheral longitudinal second conductivity-type region 117f are arranged from the end portion side at both end portions XE1 and XE2 in the x direction, the inner peripheral longitudinal first conductivity-type region 118f is arranged at both ends in a second direction central region XC inside the end portions XE1 and XE2, and second conductivity-type regions 112 and first conductivity-type regions 111 are alternately arranged along the x direction between the end portions XE1 and XE2 and the central region XC.

In this specification, a range over which the band-shape conductivity-type region (first conductivity-type region 118a in FIG. 1) arranged in contact with a boundary of the first direction end portion region with the first direction central region YC extends in the second direction is defined as the second direction central region XC, and regions at both ends of the range are defined as second direction end portion regions XE1 and XE2. When the conductivity-type region that is in contact with the boundary with the first direction central region YC is divided into a plurality of regions in the second direction, the divided portions are included in the second direction central region XC (see FIGS. 4 and 5).

The width of each of conductivity-type regions 111 and 112 arranged in the second direction central region XC is set to, for example, about 200 to 2000 µm. The width of the first conductivity-type region 111 may be different from the width of the second conductivity-type region 112. For example, the width of the second conductivity-type region may be adjusted within a range of about 0.5 to 2 times the width of the first conductivity-type region.

In first direction end portion regions YE1 and YE2, the peripheral edge lateral first conductivity-type region 116a, the outer peripheral lateral second conductivity-type region 117a and the inner peripheral lateral first conductivity-type region 118a are arranged in this order along the first direction (y direction) from the end portion of the substrate. The inner peripheral lateral first conductivity-type region 118a is connected to the inner peripheral longitudinal first conductivity-type region 118f to form the ring-shaped inner peripheral first conductivity-type region 118. The inner peripheral first conductivity-type region 118 surrounds first conductivity-type regions 111 and second conductivity-type regions 112 alternately arranged in the first direction central region YC.

The outer peripheral lateral second conductivity-type region 117a is connected to the outer peripheral longitudinal second conductivity-type region 117f to form the ring-shaped outer peripheral second conductivity-type region 117. The outer peripheral second conductivity-type region 117 surrounds the inner peripheral first conductivity-type region 118. The peripheral edge lateral first conductivity-type region 116a is connected to the peripheral edge longitudinal first conductivity-type region 116f to form the ring-shaped peripheral edge first conductivity-type region 116. The peripheral edge first conductivity-type region 116 surrounds the outer peripheral second conductivity-type region 117. The outer peripheral second conductivity-type region 117 and the peripheral edge first conductivity-type region 116 are not in contact with the first conductivity-type region 111 and second conductivity-type region 112 in the first direction central region YC.

In the solar cell of the present invention, the extending direction (first direction) of the conductivity-type region in the first direction central region and the extending direction (second direction) of the conductivity-type region in the first direction end portion region are nonparallel to each other. The first direction and the second direction are preferably perpendicular to each other. In the embodiment shown in FIG. 1, two first conductivity-type regions 118a and 116a extending in the x direction are disposed in each of first direction end portion regions YE1 and YE2, and the second conductivity-type region 117a is disposed between the first conductivity-type regions 118a and 116a. By alternately arranging first conductivity-type regions and second conductivity-type regions in the first direction end portion region, carrier recombination at the end portion of the substrate can be reduced to improve the power generation of the back contact solar cell.

Hereinafter, the probable principle for reduction of carrier recombination at the end portion of the substrate will be described on the basis of a difference in pattern shape of the conductivity-type region between the back contact solar cell shown in FIG. 1 and a conventional back contact solar cell shown in FIG. 8. In the back contact solar cell in FIG. 8, first conductivity-type regions 811 and second conductivity-type regions 812 extending in the y direction are alternately arranged in the x direction.

FIG. 10 is a photoluminescence (PL) image of a back contact solar cell in an open state, the back contact solar cell having the same pattern shape of the conductivity-type region as in FIG. 8. The back contact solar cell has a large amount of PL counts and a long carrier lifetime at the central portion of the substrate, and has a short carrier lifetime and a small number of PL counts at the end portion of the substrate.

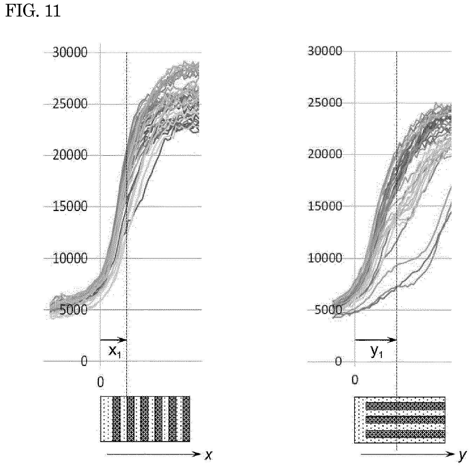

FIG. 11 shows a profile of the number of PL counts over a range of about 5 mm from the end portion of the substrate in the x direction and the y direction in the PL image in FIG. 10 together with a pattern of the conductivity-type region at the end portion. In each of the x direction and the y direction, the number of PL counts at the end portion of the substrate (= background) is about 5000, and the number of PL counts increases as going toward the center of the substrate. There is a difference in rise in the number of PL counts between the x direction and the y direction, and where the distance from the end portion to a point at which the number of PL counts reaches 20000 is y₁ in the y direction and x₁ in the x direction, the distance y₁ is about two times the distance x₁. It is apparent that the back contact solar cell has a smaller number of PL counts and a shorter carrier lifetime at the end portion in the y direction than at the end portion in the x direction. This indicates that the carrier recombination amount is larger in the vicinity of the end portion in the y direction than in the vicinity of the end portion in the x direction.

The reason why the carrier recombination amount is large in the vicinity of the end portion in the y direction is that the potential barrier is lower when carriers move toward the end portion in the y direction than when carriers move toward the end portion in the x direction. It is considered that the carrier recombination amount is large in the vicinity of the end portion in the y direction because carriers produced at the central portion of the substrate easily move in the surface direction of the substrate to arrive at the end portion in the y direction.

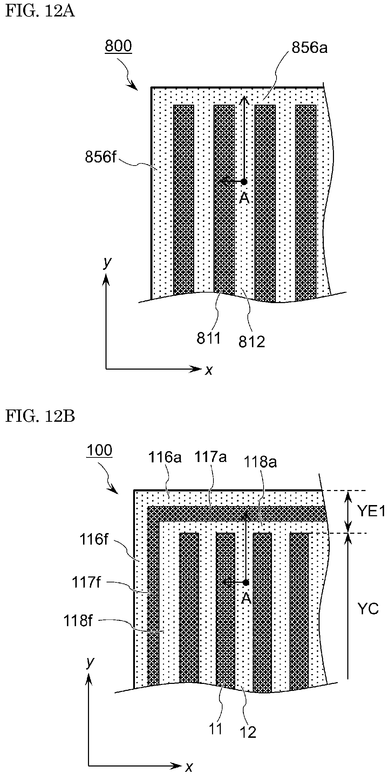

When first conductivity-type regions 811 and second conductivity-type regions 812 extending in the y direction are alternately arranged along the x direction as conceptually shown in FIG. 12A, there is a potential gradient at a boundary between the first conductivity-type region and the second conductivity-type region in the x direction. The potential gradient serves as a barrier, so that movement of carriers in the x direction is suppressed. Thus, there is a low probability that carriers produced at position A in the central portion of the substrate moves in the x direction to arrive at the end portion region 856f. Referring to FIG. 11, the number of PL counts reaches 20000 in the vicinity of a boundary between the first conductivity-type region which is second closest to the end portion in the x direction and the second conductivity-type region which is the second closest to the end portion in the x direction.

On the other hand, since there is no conductivity-type region boundary in the y direction that is the extending direction of the conductivity-type region 812, the potential barrier is smaller in movement of carriers in the y direction than in movement of carriers in the x direction. Thus, it is considered that in the y direction, a large amount of carriers arrive at the end portion region 856a, leading to an increase in carrier recombination amount in the vicinity of the end portion of the substrate.

In particular, a heterojunction solar cell in which a passivation layer such as an amorphous silicon layer is disposed on a surface of a silicon substrate has a long carrier lifetime, and a long distance over which carriers can move in the substrate. Thus, the amount of carriers moving from the central portion to the end portion in the y direction tends to be so large that a carrier collecting loss caused by recombination of carriers moving to the end portion exerts a marked effect.

On the other hand, in the embodiment shown in FIG. 12B, the inner peripheral lateral first conductivity-type region 118a, the outer peripheral lateral second conductivity-type region 117a and the peripheral edge lateral first conductivity-type region 116a are arranged in this order from the first direction central region YC side in the first direction end portion region YE1. Thus, as conceptually shown in FIG. 12B, a potential barrier at a boundary between the first conductivity-type region 118a and the second conductivity-type region 117a and a potential barrier at a boundary between the second conductivity-type region 117a and the first conductivity-type region 116a serve as a factor of hindering movement of carriers produced at position A in the central portion of the substrate to the end portion in the y direction (peripheral edge lateral first conductivity-type region 118a).

In other words, in the solar cell of the present invention, first conductivity-type regions and second conductivity-type regions extending in the second direction (x direction) are alternately arranged in the first direction end portion region, and therefore by potential barriers at boundaries between these conductivity-type regions, movement of carriers to the end portion in the first direction (y direction) is limited. In the embodiment shown in FIG. 1, two first conductivity-type regions 116a and 118a are present in each of first direction end portion regions YE1 and YE2, and the second conductivity-type region 117a is present between the first conductivity-type regions 116a and 118a. For arriving at the end portion in the first direction, carriers produced in the first direction central region YC are required to pass over both the potential barrier in movement from the first conductivity-type region 118a to the second conductivity-type region 117a and the potential barrier in movement from the second conductivity-type region 117a to the first conductivity-type region 116a. Thus, movement of carriers to the end portion of the substrate in the first direction is suppressed, and accordingly, the carrier recombination amount at the end portion in the first direction is reduced, so that the power of the solar cell is improved.

The pattern shape of first conductivity-type regions and second conductivity-type regions in the first direction end portion region is not limited to the form shown in FIG. 1, as long as first conductivity-type regions and second conductivity-type regions are alternately arranged along the first direction. For example, two or more second conductivity-type regions extending in the second direction may be provided, and three or more first conductivity-type regions may be provided. The conductivity-type region arranged on the innermost side (on a side close to the first direction central region YC) in the first direction end portion region may be either the first conductivity-type region or the second conductivity-type region.

The larger the number of alternately arranged first conductivity-type regions and second conductivity-type regions provided in the first direction end portion region, the greater the barrier in movement of carriers from the central portion of the substrate to the end portion in the first direction. Thus, the probability that photocarriers produced at the central portion move to the end portion of the substrate to be recombined tends to decrease, leading to improvement of carrier collecting efficiency.

On the other hand, when the number of alternately arranged first conductivity-type regions and second conductivity-type regions provided in the first direction end portion region increases, the width of the first direction end portion region increases. Accordingly, the movement distance until photocarriers produced at the end portion of the substrate move to the electrode arranged at the central portion may increase, leading to deterioration of collecting efficiency of carriers produced in the first direction end portion region. Thus, the number of first conductivity-type regions provided along the first direction in each of first direction end portion regions YE1 and YE2 is preferably 10 or less, more preferably 6 or less, further preferably 5 or less. The width of each of first direction end portion regions YE1 and YE2 from the end portion of the substrate in the first direction is preferably 3 mm or less, more preferably 1.5 mm or less.

First conductivity-type regions and second conductivity-type regions arranged in the first direction end portion region are not required to be connected to the conductivity-type region arranged in the first direction central region. For example, in the embodiment shown in FIG. 3, two first conductivity-type regions 316a and 318a and two second conductivity-type regions 317a and 319a are alternately arranged in each of first direction end portion regions YE1 and YE2. First conductivity-type regions 316a and 318a are connected to the outer peripheral longitudinal first conductivity-type region 316f extending in the first direction. The second conductivity-type region 319a is connected to the inner peripheral longitudinal second conductivity-type region 319f, and a plurality of conductivity-type regions 312 arranged in the second direction central region XC.

On the other hand, the second conductivity-type region 317a is not connected to the second conductivity-type region extending in the first direction. Even when the conductivity-type region arranged in the first direction end portion region is not connected to the conductivity-type region extending in the first direction, a potential barrier is present at a boundary between adjacent first conductivity-type regions 316a and 318a. That is, irrespective of whether or not the conductivity-type region extending in the second direction is connected to the conductivity-type region extending in the first direction, movement of carriers to the end portion in the first direction can be suppressed by the potential barrier, and therefore it is possible to contribute to reduction of carrier recombination at the end portion of the substrate.

First conductivity-type regions and second conductivity-type regions arranged in the first direction end portion region are not required to be continuous throughout the second direction. For example, in the embodiment shown in FIG. 4, first conductivity-type regions 433 and 434 extend over first direction end portion regions YE1 and YE2 from the first direction central region YC in the first direction, and are connected to a peripheral edge lateral first conductivity-type region 416a in the first direction end portion region YE1. Thus, the second conductivity-type region arranged inside the first conductivity-type region 416a is divided into three regions: regions 417a, 417b and 417c extending in the second direction. The first conductivity-type region arranged inside the second conductivity-type region is also divided into three regions: regions 418a, 418b and 418c.

Thus, when the conductivity-type region arranged in the first direction end portion region is divided into a plurality of regions in the second direction, collecting efficiency of photocarriers produced in the first direction end portion region can be improved. To be more specific, photocarriers produced at the end portion of the substrate can be collected by metal electrodes 443 and 444 disposed on first conductivity-type regions 433 and 434 since the peripheral edge lateral first conductivity-type region 416a is connected to first conductivity-type regions 433 and 434. Since the peripheral edge lateral first conductivity-type region 416a is connected to a plurality of first conductivity-type regions extending in the first direction, the movement distance in the second direction until photocarriers produced in the first direction end portion region are collected by metal electrodes decreases. Thus, the ratio at which carriers are collected by metal electrodes 443 and 444 disposed on the first conductivity-type region before the carries are recombined at the end portion of the substrate increases, so that a loss caused by carrier recombination at the end portion of the substrate can be reduced.

The larger the number of band-shape first conductivity-type regions, which extend over first direction end portion regions YE1 and YE2 from the first direction central region YC in the first direction and are connected to the peripheral edge first conductivity-type region 116a, among those arranged in the second direction central region XC, the smaller the carrier movement distance in the second direction. In FIG. 4, total fourteen band-shape first conductivity-type regions extending in the first direction are present in the second direction central region XC, and among them, twelve first conductivity-type regions are connected to first conductivity-type regions 418a, 418b and 418c arranged inside, and two first conductivity-type regions 433 and 434 are connected to the peripheral edge lateral first conductivity-type region 416a.

Since two first conductivity-type regions 433 and 434 are connected to the peripheral edge lateral first conductivity-type region 416a, the first direction end portion region is divided into three regions along the second direction. Thus, the carrier movement distance in the second direction is about one-third of that when first conductivity-type regions extending in the first direction are not connected to the peripheral edge lateral first conductivity-type region (see FIG. 1). In other words, the larger the number of first conductivity-type regions connected to the peripheral edge lateral first conductivity-type region 416a, among first conductivity-type regions extending in the first direction, the smaller the movement distance until photocarriers produced in first direction end portion regions YE1 and YE2 are collected by metal electrodes. Accordingly, recombination of photocarriers produced in the first direction end portion region can be suppressed.

On the other hand, in first conductivity-type regions 433 and 434 connected to the peripheral edge lateral first conductivity-type region 416a, the potential barrier in movement of carriers from the first direction central region to the end portion in the first direction is small, so that photocarriers produced in the first direction central region YC easily move to the peripheral edge lateral first conductivity-type region 416a. In other words, since first conductivity-type regions 433 and 434 are connected to the peripheral edge lateral first conductivity-type region 416a, collecting efficiency of photocarriers produced in the first direction end portion region can be improved, but in these conductivity-type regions, a carrier recombination loss caused by movement of photocarriers produced in the first direction central region to the end portion of the substrate tends to increase.

When the ratio of first conductivity-type regions connected to the peripheral edge lateral first conductivity-type region 416a is excessively high, the effect of an increase in the amount in which photocarriers produced at the central portion of the substrate are recombined at the end portion of the substrate may exceed the effect of improving carrier collecting efficiency by reduction of the distance over which photocarriers produced at the end portion of the substrate move in the second direction. For optimizing carrier collecting efficiency in terms of a balance between these effects, the ratio of band-shape first conductivity-type regions connected to the peripheral edge lateral first conductivity-type region 416a, among those that are arranged in the second direction central region and extend in the first direction, is preferably 30% or less, more preferably 0.5 to 20%, further preferably 1 to 10%. For suppressing movement of photocarriers produced in the first direction central region to the end portion of the substrate, the ratio of band-shape first conductivity-type regions connected to first conductivity-type regions 418a, 418b and 418c arranged inside the peripheral edge lateral first conductivity-type region 416a in the first direction end portion region, among those that are arranged in the second direction central region XC and extend in the first direction, is preferably 50% or more, more preferably 70% or more, further preferably 80% or more, especially preferably 90% or more.

When the peripheral edge lateral first conductivity-type region 416a is connected to band-shape first conductivity-type regions 433 and 434 extending in the first direction, second conductivity-type regions and first conductivity-type regions arranged inside the peripheral edge lateral first conductivity-type region (on a side close to the first direction central region YC) are each divided into a plurality of regions along the second direction. Even in these conductivity-type regions, the distance over which produced photocarriers move in the second direction decreases, so that carrier collecting efficiency tends to be improved.

Among the band-shape conductivity-type regions that are arranged in first direction end portion regions YE1 and YE2 and extend in the second direction, conductivity-type regions 418a, 418b and 418c that are in contact with the first direction central region YC may be provided with metal electrodes 428a, 428b and 428c extending in the second direction. When these metal electrodes are connected to a metal electrode 421 disposed on a conductivity-type region 411 extending in the first direction, the ratio of carriers collected by metal electrodes increases. Thus, the number of carriers moving to the end portion in the first direction tends to relatively decrease, leading to reduction of the carrier recombination amount at the end portion in the first direction.

Metal electrodes 427a, 427b and 427c extending in the second direction may also be disposed on conductivity-type regions 417a, 417b and 417c arranged outside the conductivity-type regions 418a, 418b and 418c (on the substrate end portion side). Preferably, metal electrodes 427a, 427b and 427c are each connected to metal electrodes 447 and 448 disposed on conductivity-type regions 436 and 437 extending in the first direction.

Even when metal electrodes are not provided in first conductivity-type regions 418a, 418b and 418c each divided into a plurality of regions along the x direction, and second conductivity-type regions 417a, 417b and 417c, photocarriers produced in these conductivity-type regions can be effectively collected by metal electrodes extending in the y direction because the movement distance in the x direction is small.

The peripheral edge lateral first conductivity-type region 416a and a peripheral edge longitudinal first conductivity-type region 416f may also be provided with metal electrodes. The metal electrode disposed on the peripheral edge lateral first conductivity-type region 416a may be connected to metal electrodes 443 and 444 extending in the y direction.

FIG. 4 shows an embodiment in which in each of first direction end portion regions YE1 and YE2, two first conductivity-type regions are present along the first direction, and a second conductivity-type region is present between the two first conductivity-type regions, but two second conductivity-type regions may be provided along the first direction as shown in FIG. 5. In addition, in the first direction end portion region, three or more first conductivity-type regions and second conductivity-type regions may be provided along the first direction.

It is preferable that even when conductivity-type regions 519a, 519b and 519c that are in contact with the first direction central region YC are second conductivity-type regions, these regions are provided with metal electrodes 529a, 529b and 529c as shown in FIG. 5. Metal electrodes may also be disposed on first conductivity-type regions and second conductivity-type regions arranged outside the above-mentioned second conductivity-type regions (on the substrate end portion side).

FIGS. 1 and 3 to 5 show an example in which conductivity-type region patterns in two first direction end portion regions YE1 and YE2 are symmetric along the first direction, but conductivity-type region patterns in the two first direction end portion regions are not required to be symmetric. For example, the numbers and pattern shapes of conductivity-type regions arranged in the two first direction end portion regions may be mutually different.

In the example shown in FIG. 6, a first conductivity-type region 616a, second conductivity-type region 617a, a first conductivity-type region 618a and a second conductivity-type region 619a are arranged in this order from the end portion toward the inside in the first direction in one first direction end portion region YE1, and a first conductivity-type region 616b, a second conductivity-type region 617b and a first conductivity-type region 618b are arranged in this order from the end portion toward the inside in the first direction in the other first direction end portion region YE2. In this embodiment, two second conductivity-type regions 617a and 619a are provided in one first direction end portion region YE1, whereas one second conductivity-type region 617b is provided in the other first direction end portion region YE2, so that a vertically asymmetrical shape is formed.

A metal electrode 629 extending in the second direction is disposed on the second conductivity-type region 619a in the first direction end portion region YE1, and the metal electrode is connected to a metal electrode 622 disposed on a second conductivity-type region 612 extending in the first direction. A metal electrode 628 extending in the second direction is disposed on the first conductivity-type region 618b in the first direction end portion region YE2, and the metal electrode is connected to a metal electrode 621 disposed on a first conductivity-type region 611 extending in the first direction. Thus, the first conductivity-type region and the second conductivity-type region are arranged in an interdigitated comb teeth shape, and outside the conductivity-type regions (on the end portion side in the first direction), first conductivity-type regions and second conductivity-type regions are alternately arranged.

### [Modularization]

A plurality of back contact cells are electrically connected through a wiring member to modularize the cells.

In a solar cell 600 shown in FIG. 6, a first conductivity-type region and a second conductivity-type region are arranged in an interdigitated comb teeth shape. A plurality of first finger electrodes 621 extending in the first direction are connected to a first bus bar electrode 628 extending in the second direction, and a plurality of second finger electrodes 622 extending in the first direction are connected to a second bus bar electrode 629 extending in the second direction. When as described above, all metal electrodes disposed on the first conductivity-type region are connected, and all metal electrodes disposed on the second conductivity-type region are connected, carriers collected by all the metal electrodes can be extracted through a wiring member by connecting each of the metal electrodes on the first conductivity-type region and the metal electrodes on the second conductivity-type region to the wiring member (interconnector).

For example, when the first bus bar electrode 628 disposed on the first direction end portion region YE2 is connected through an interconnector to a bus bar electrode disposed on a second conductivity-type region of a solar cell adjacent to one side (lower side in FIG. 6), and the second bus bar electrode 629 disposed on the first direction end portion region YE1 is connected through an interconnector to a bus bar electrode disposed on a first conductivity-type region of a solar cell adjacent to the other side (upper side in FIG. 6), adjacent solar cells can be electrically connected in series.

When first finger electrodes 21 and second finger electrodes 22 extending in the first direction are alternately arranged along the x direction, and the finger electrodes are separated from one another as in the solar cell 100 shown in FIG. 1, it is necessary to establish electrical connection between finger electrodes and electrical connection between adjacent solar cells through an interconnector. In this form, a wiring sheet including metal electrodes patterned on a base material such as a film or glass can be used as the interconnector.

The metal electrodes of the wiring sheet include finger electrode sections substantially identical in shape to finger electrodes 21 and 22 of the solar cell, and bus bar electrode sections connecting the finger electrode sections. By disposing the solar cell on the wiring sheet, and connecting the finger electrodes of the solar cell and the finger electrodes of the wiring sheet, carriers in all finger electrodes can be gathered through the bus bar sections of the wiring sheet. In addition, electrical connection between adjacent solar cells can be performed through the bus bar sections of the wiring sheet. For a solar cell 300 shown in FIG. 3, electrical connection between finger electrodes and electrical connection between adjacent solar cells can be performed using the wiring sheet.

When finger electrodes 422 on the second conductivity-type region are present in an island shape while being surrounded by metal electrodes disposed on the first conductivity-type region as in a solar cell 400 shown in FIG. 4, it is difficult to perform electrical connection between electrodes by a wiring sheet with a metal electrode pattern formed on only one principal surface of a base material. When a wiring sheet is used in which a metal electrode pattern is formed on each of both surfaces of a base material, and the metal electrode patterns on the front and back sides are in continuity with each other through a via hole formed in the base material, the solar cells shown in FIGS. 4 and 5 can be modularized.

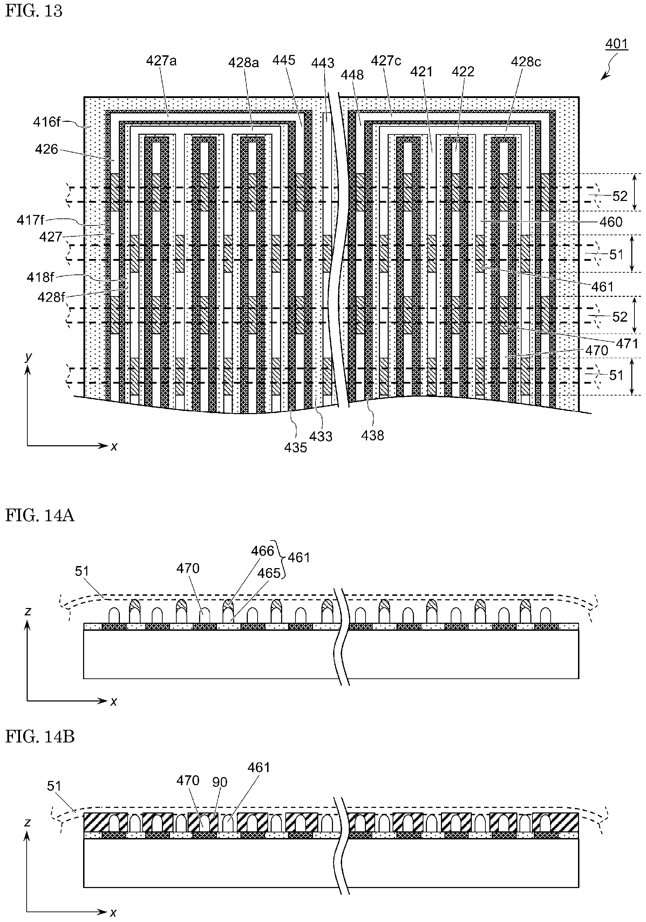

When the finger electrode of the solar cell includes a non-mounting electrode section and a wiring-mounting electrode section, and an interconnector is mounted onto the wiring-mounting electrode section, electrical connection between electrodes can be more conveniently performed. FIG. 13 is a plan view of a solar cell 401 having the same conductivity-type region pattern shape as in the solar cell 400 in FIG. 4.

In the solar cell 401, metal electrodes 427f, 422 and 443 (hereinafter, these metal electrodes may be collectively referred to as a first finger electrode) that are disposed on the first conductivity-type region and extend in the first direction (y direction) each have a non-mounting electrode section 460 and a wiring-mounting electrode section 461. Metal electrodes 428f, 445 and 448 (hereinafter, these metal electrodes may be collectively referred to as a second finger electrode) that are disposed on the second conductivity-type region and extend in the first direction each have a non-mounting electrode section 470 and a wiring-mounting electrode section 471.

In modularization of the solar cell, a band-shape first wiring member 51 is disposed so as to pass over wiring-mounting electrode sections 461 of a plurality of first finger electrodes and non-mounting electrode sections 470 of a plurality of second finger electrodes. The first wiring member 51 is in contact with, and electrically connected to the wiring-mounting electrode sections 461 of the first finger electrodes, and is not electrically connected to the non-mounting electrode sections 470 of the second finger electrodes. In other words, the first wiring member electrically connects a plurality of first finger electrodes of the solar cell 401, and is not electrically connected to the second finger electrodes.

A band-shape second wiring member 52 is disposed so as to pass over non-mounting electrode sections 460 of a plurality of first finger electrodes and wiring-mounting electrode sections 471 of a plurality of second finger electrodes. The second wiring member 52 is in contact with, and electrically connected to the wiring-mounting electrode sections 471 of the second finger electrodes, and is not electrically connected to the non-mounting electrode sections 460 of the first finger electrodes. In other words, the second wiring member electrically connects a plurality of second finger electrodes of the solar cell 401, and is not electrically connected to the second finger electrodes.

Thus, the wiring-mounting electrode sections 461 and 471 of finger electrodes are regions which are electrically connected to the wiring member, and the non-mounting electrode sections 460 and 470 are regions which are inhibited from being electrically connected to wiring members 51 and 52.

For example, when as shown in the sectional view in FIG. 14A, the electrode height of the wiring-mounting electrode section is made relatively high, and the electrode height of the non-mounting electrode section is made relatively small, electrical connection between the non-mounting electrode section and the wiring member is inhibited to selectively connect the wiring member onto the wiring-mounting electrode section.

Although the electrode height in the wiring-mounting electrode section is preferably uniform, process-dependent variation may occur. Even when the electrode height is not uniform, it suffices that an imaginary line connecting the tops of the wiring-mounting electrode sections of two adjacent first finger electrodes (two first finger electrodes adjacent to one second finger electrode) does not cross the second finger electrode disposed therebetween. In other words, it suffices that when a straight line is drawn between the tops of adjacent first finger electrodes, the height of the drawn straight line is larger than the height of the second finger electrode existing between the first finger electrodes. The height-direction distance between an imaginary line connecting the tops of two first finger electrodes and the top of the second finger electrode disposed therebetween is preferably 1 µm or more, more preferably 5 µm or more.

Similarly, for preventing the second wiring member 52 and the first finger electrode from coming into contact with each other, it suffices that an imaginary line connecting the tops of the wiring-mounting electrode sections of two adjacent second finger electrodes does not cross the first finger electrode disposed between the second finger electrodes. The height-direction distance between an imaginary line connecting the tops of two second finger electrodes and the top of the first finger electrode disposed therebetween is preferably 1 µm or more, more preferably 5 µm or more.

The electrode height of each of the wiring-mounting electrode sections 461 and 471 is preferably larger than by 1 µm or more than the electrode height of each of the non-mounting electrode sections 460 and 470. The difference between the heights of the wiring-mounting electrode section and the non-mounting electrode section is preferably 1 to 150 µm, more preferably 5 to 80 µm. The electrode height is a distance between the substrate surface and the top of the electrode. When there exists a region where the substrate has a reduced thickness on a partial basis due to, for example, etching for formation of a semiconductor layer, the distance between a reference plane and the top of the electrode may be defined as an electrode height, the reference plane being parallel to the substrate surface.

The method for providing a wiring-mounting electrode section having a larger electrode height as compared to the height in the surrounding is not particularly limited. For example, a wiring-mounting electrode section having a large electrode height 461 can be formed by forming an electrode 465, 470 having a uniform height, and thereafter performing printing or plating on the electrode 465. The material of a bulky part 466 of the wiring-mounting electrode section may be identical to or different from the material of other region of the electrode.

Electrical connection between the non-mounting electrode section on the finger electrode and the wiring member can also be inhibited by a method other than a method in which a height difference is provided on the electrode. For example, when the non-mounting electrode section 470 is covered with an insulating layer 90 as shown in the sectional view in FIG. 14B, electrical connection between the non-mounting electrode section and the wiring member can be inhibited to selectively electrically connect the wiring member 51 and the wiring-mounting electrode section 461 which is not covered with the insulating layer.

Examples of the method for selectively covering non-mounting electrode sections 460 and 470 with the insulating layer 90 include a method in which an insulating paste is applied onto the non-mounting electrode section, and dried; a method in which an insulating layer is formed over the entire surface, and the insulating layer on wiring-mounting electrode sections 461 and 471 is then removed by etching or the like to expose electrodes; and a method in which an insulating layer is deposited with using a mask, etc. so that wiring-mounting electrode sections 461 and 471 are not covered with the insulating layer.

In each of the first finger electrodes, it is preferable the wiring-mounting electrode section 461 is arranged in the same y coordinate region. In each of the second finger electrodes, it is preferable the wiring-mounting electrode section 471 is arranged in the same y coordinate region. When wiring-mounting electrode sections are linearly arranged, a plurality of first finger electrodes can be electrically connected by mounting the first wiring member 51 onto the wiring-mounting electrode section 461 of the first finger electrode, and a plurality of second finger electrodes can be electrically connected by mounting the second wiring member 52 onto the wiring-mounting electrode section 471 of the second finger electrode.

When the first wiring member 51 is mounted onto the second finger electrode of a solar cell arranged adjacent to the solar cell 401 in the second direction, and the second wiring member 52 is mounted onto the first finger electrode of the solar cell arranged adjacent to the solar cell 401 in the second direction, adjacent solar cells can be connected in series. When the first wiring member 51 is mounted onto the first finger electrode of a solar cell arranged adjacent to the solar cell 401 in the second direction, and the second wiring member 52 is mounted onto the second finger electrode of the solar cell arranged adjacent to the solar cell 401 in the second direction, adjacent solar cells can be connected in parallel. Wiring members 51 and 52 are not necessarily required to have a band-shape, and may be a wire or the like having a circular cross-section as long as they can be electrically connected to the wiring-mounting electrode section of the finger electrode.

When the first finger electrode and the second finger electrode each extending in the first direction (y direction) are arranged alternately in the second direction (x direction) perpendicular to the first direction, the extending direction of the wiring member is preferably parallel to the second direction. Specifically, the angle formed by the extending direction of the wiring members 51 and 52 and the second direction is preferably 5° or less, more preferably 3° or less, further preferably 1° or less. The angle formed by the extending direction of the wiring member and the second direction is ideally 0°. However, making the arrangement angle of the wiring member always constant with high accuracy is not easy.

Mounting the wiring member onto the wiring-mounting electrode section of the finger electrode has the advantage that alignment between electrodes of the solar cells and wiring members is easier and the allowable range of the arrangement angle of the wiring member is wider as compared to connection of the finger electrode using a wiring sheet. For example, when the length of the wiring-mounting electrode section 461 in the extending direction (y direction) of the first finger electrode is larger than the width of the wiring member in mounting the wiring member 51 onto the wiring-mounting electrode section 461 of the finger electrode, the allowable range of arrangement angle displacement of the wiring member can be increased. Thus, the connection process between the electrode of the solar cell and the wiring member can be simplified, and the yield of the solar cell module can be improved.

The distance (carrier collection distance) over which carriers collected in a semiconductor layer move across the finger electrodes until reaching the wiring member decreases, when each of the finger electrodes include a non-mounting electrode section and a wiring-mounting electrode section, and the wiring-mounting electrode sections of the plurality of finger electrodes are connected through a wiring member. For example, when the wiring-mounting electrode section exists near the center of the finger electrode in the extending direction (y direction), the carrier collection distance is about half the length of the finger electrode.

When one finger electrode includes a plurality of wiring-mounting electrode sections along the extending direction as shown in FIG. 13, the carrier collection distance is further decreased. Thus, an electrical loss caused by resistance of the electrode can be reduced to improve module characteristics (particularly the fill factor).

When one finger electrode includes a plurality of wiring-mounting electrode sections, there is the advantage that a loss caused by a contact failure between the wiring member and the wiring-mounting electrode section can be reduced in addition to reduction of an electrical loss caused by reduction of the carrier collection distance of the finger electrode. When the number of connecting portion of one finger electrode to the wiring member is only one, carriers of a finger electrode in which a contact failure with the wiring member occurs cannot be extracted to outside of the solar cell, and this leads to a complete loss.

On the other hand, when one finger electrode includes a plurality of wiring-mounting electrode sections each connected to a wiring member, carriers can be extracted to outside through a connection part where a wiring-mounting electrode section is connected to the wiring member, even if a contact failure with the wiring member occurs in one wiring-mounting electrode section. In this case, occurrence of a complete carrier collection loss can be avoided, although the carrier collection distance increases due to a contact failure with the wiring member. Thus, a considerable electrical loss caused by a contact failure can be avoided.

The method in which an interconnector is mounted to a wiring-mounting electrode section of the finger electrode having a non-mounting electrode section and the wiring-mounting electrode section is applicable to solar cells other than those shown in FIGS. 4 and 5. Even when this method is applied to the solar cell 100 shown in FIG. 1, the solar cell 300 shown in FIG. 3 and the solar cell 600 shown in FIG. 6, a high-efficiency solar cell module can be produced with a high yield because effects such as simplification of alignment, reduction of the carrier collection distance and reduction of a loss caused by a contact failure can be exhibited as compared to a case where interconnection is performed using a wiring sheet.

### DESCRIPTION OF REFERENCE CHARACTERS

- 100, 300, 400, 401, 500, 600: solar cell
- 10: semiconductor substrate
- 11, 12: conductive semiconductor layer
- 31, 32: intrinsic semiconductor layer
- 41, 42: transparent electroconductive layer
- 21, 22: metal electrode (finger electrode)
- 70: passivation layer
- 111, 116a, 116f, 118a, 118f: first conductivity-type region
- 112, 117a, 117f: second conductivity-type region
- 460, 470: non-mounting electrode section
- 461, 471: wiring-mounting electrode section 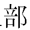
- 51, 52: wiring member

## Claims

1. A solar cell (400) comprising a rectangular-shaped semiconductor substrate (10) having a first principal surface and a second principal surface, the second principal surface including first conductivity-type regions and second conductivity-type regions, wherein
a metal electrode is disposed on the second principal surface, and no metal electrode is provided on the first principal surface,
the first conductivity-type regions include a first conductivity-type semiconductor layer, and the second conductivity-type regions include a second conductivity-type semiconductor layer having a conductivity-type different from that of the first conductivity-type semiconductor layer,
a first direction end portion region (YE1, YE2) is present at each of both end portions of the semiconductor substrate in a first direction, and a first direction central region (YC) is present between the two first direction end portion regions (YE1, YE2) with, in the first direction central region (YC),
- first conductivity-type regions (433, 411, 434) having a band-shape extending in the first direction and second conductivity-type regions (436, 412, 437) having a band-shape extending in the first direction, alternately arranged along a second direction,
wherein in each of the first direction end portion regions (YE1, YE2), a peripheral edge lateral first conductivity-type region (416a), an outer peripheral lateral second conductivity-type region (417a, 417b, 417c) and a first conductivity-type region (418a, 418b, 418c) each having a band-shape extending in the second direction are arranged in this order along the first direction from the end portion of the semiconductor substrate,
**characterized in that**
at least one first conductivity-type region (433, 434) extends over the first direction end portion regions (YE1, YE2) from the first direction central region (YC) in the first direction, and is connected to the peripheral edge lateral first conductivity-type region (416a), and
the outer peripheral lateral second conductivity-type region, which is arranged adjacent to the peripheral edge lateral first conductivity-type region (416a), is divided into a plurality of regions (417a, 417b, 417c) along the second direction by the at least one first conductivity-type region (433, 434) that is connected to the peripheral edge lateral first conductivity-type region (416a).

2. The solar cell according to claim 1, wherein
in the first direction central region (YC), an intrinsic semiconductor layer (31), the first conductivity-type semiconductor layer (11) and a transparent electroconductive layer (41) are disposed in this order on the second principal surface of the semiconductor substrate in the first conductivity-type region (111), and an intrinsic semiconductor layer (32), the second conductivity-type semiconductor layer (12) and a transparent electroconductive layer (42) are disposed in this order on the second principal surface of the semiconductor substrate in the second conductivity-type region (112).

3. The solar cell according to claim 1 or 2, wherein
among the first conductivity-type regions arranged in a second direction central region (XC), a ratio of the first conductivity-type region (433, 434) that is connected to the peripheral edge lateral first conductivity-type region (416a) is 30% or less,
where the second direction central region (XC) is defined as a range over which a conductivity-type region (428a, 428b, 428c) arranged in the first direction end portion region (YE1, YE2) and in contact with the first direction central region (YC) is extending in the second direction.

4. The solar cell according to any one of claims 1 to 3, wherein a metal electrode (428a, 428b, 428c) extending in the second direction is disposed in a conductivity-type region (418a, 4718b, 418c) arranged in contact with a boundary of the first direction end portion region (YE1, YE2) with the first direction central region (YC).

5. The solar cell according to claim 4, wherein the metal electrode (428b) extending in the second direction is connected to the metal electrode (421) which is disposed in the conductivity-type region (411) arranged in the first direction central region (YC), and extends in the first direction.

6. The solar cell according to any one of claims 1 to 5, wherein
the metal electrode (421, 422) disposed in the conductivity-type region arranged in the first direction central region (YC) has a non-mounting electrode section (460, 470) and a wiring-mounting electrode section (461, 471), and
the non-mounting electrode section (460, 470) is a region which is inhibited from being electrically connected to a wiring member (51, 52) when the wiring member (52, 51) is disposed on the region.

7. The solar cell according to claim 6, wherein the wiring-mounting electrode section (461, 471) has an electrode height larger than the electrode height of the non-mounting electrode section (460, 470).

8. The solar cell according to claim 6, wherein
the metal electrode (421, 422) is covered with an insulating layer (90) in the non-mounting electrode section (460, 470), and the metal electrode (421, 422) is exposed without being covered with an insulating layer in the wiring-mounting electrode section (461, 471).

9. The solar cell according to any one of claims 6 to 8,
wherein the metal electrode (421) disposed in the first conductivity-type region arranged in the first direction central region (YC) has a non-mounting electrode section (460) and wiring-mounting electrode section (461),
the metal electrode (422) disposed in the second conductivity-type region arranged in the first direction central region (YC) has a non-mounting electrode section (470) and a wiring-mounting electrode section (471),
wiring-mounting electrode sections (461) of metal electrodes (421) on a plurality of first conductivity-type regions are present side by side along the second direction, and
wiring-mounting electrode sections (471) of metal electrodes (422) on a plurality of second conductivity-type regions are present side by side along the second direction.

10. A solar cell module, comprising a plurality of the solar cells according to any one of claims 1 to 9, and the solar cells are connected through a wiring member.

11. A solar cell module comprising a plurality of the solar cells according to any one of claims 6 to 9, wherein
each of the solar cells (401) is electrically connected to wiring members (51, 52),
the wiring-mounting electrode section (461) of the metal electrode (421) arranged in the first conductivity-type region is electrically connected to a first wiring member (51), and
the wiring-mounting electrode section (471) of the metal electrode (422) arranged in the second conductivity-type region is electrically connected to a second wiring member (52).

## Patentansprüche

1. Solarzelle (400), umfassend ein rechteckiges Halbleitersubstrat (10), das eine erste Hauptoberfläche und eine zweite Hauptoberfläche aufweist, wobei die zweite Hauptoberfläche Bereiche eines ersten Leitfähigkeitstyps und Bereiche eines zweiten Leitfähigkeitstyps einschließt, wobei
eine Metallelektrode auf der zweiten Hauptoberfläche angeordnet ist, und keine Metallelektrode auf der ersten Hauptoberfläche bereitgestellt ist,
die Bereiche des ersten Leitfähigkeitstyps eine Halbleiterschicht des ersten Leitfähigkeitstyps einschließen, und die Bereiche des zweiten Leitfähigkeitstyps eine Halbleiterschicht des zweiten Leitfähigkeitstyps einschließen, die einen Leitfähigkeitstyp aufweist, der sich von dem der Halbleiterschicht des ersten Leitfähigkeitstyps unterscheidet,
ein Endabschnittsbereich (YE1, YE2) einer ersten Richtung an jedem der beiden Endabschnitte des Halbleitersubstrats vorhanden ist und ein zentraler Bereich (YC) der ersten Richtung zwischen den zwei Endabschnittsbereichen (YE1, YE2) der ersten Richtung mit dem zentralen Bereich (YC) der ersten Richtung vorhanden ist,
- Bereiche des ersten Leitfähigkeitstyps (433, 411, 412, 434) mit einer Bandform, die sich in der ersten Richtung erstreckt, und Bereiche des zweiten Leitfähigkeitstyps (436, 412, 437) mit einer Bandform, die sich in der ersten Richtung erstreckt, abwechselnd entlang einer zweiten Richtung angeordnet sind, wobei
in jedem der Endabschnittsbereiche (YE1, YE2) der ersten Richtung ein seitlicher Peripherierandbereich des ersten Leitfähigkeitstyps (416a), ein äußerer seitlicher Peripheriebereich des zweiten Leitfähigkeitstyps (417a, 417b, 417c) und ein Bereich des ersten Leitfähigkeitstyps (418a, 418b, 418c), jeweils mit einer Bandform, die sich in der zweiten Richtung erstreckt, in dieser Reihenfolge entlang der ersten Richtung vom Endabschnitt des Halbleitersubstrats angeordnet sind,
**dadurch gekennzeichnet, dass**
wenigstens ein Bereich (433, 434) des ersten Leitfähigkeitstyps sich über die Endabschnittsbereiche (YE1, YE2) der ersten Richtung von dem zentralen Bereich (YC) der ersten Richtung der ersten Richtung erstreckt und mit dem seitlichen Peripherierandbereich des ersten Leitfähigkeitstyps (416a) verbunden ist, und
der äußerer seitlicher Peripheriebereich des zweiten Leitfähigkeitstyps, der benachbart zu dem seitlichen Peripherierandbereich (416a) des ersten Leitfähigkeitstyps angeordnet ist, in mehrere Bereiche (417a, 417b, 417c) entlang der zweiten Richtung durch den wenigstens einen Bereich (433, 434) des ersten Leitfähigkeitstyps geteilt ist, der mit dem seitlichen Peripherierandbereich des ersten Leitfähigkeitstyps (416a) verbunden ist.

2. Solarzelle nach Anspruch 1, wobei
in dem zentralen Bereich (YC) der ersten Richtung eine intrinsische Halbleiterschicht (31), die Halbleiterschicht (11) des ersten Leitfähigkeitstyps und eine transparente elektrisch leitende Schicht (41), in dieser Reihenfolge, auf der zweiten Hauptoberfläche des Halbleitersubstrats in dem Bereich (111) des ersten Leitfähigkeitstyps angeordnet sind, und eine intrinsische Halbleiterschicht (32), die Halbleiterschicht (12) des zweiten Leitfähigkeitstyps und eine transparente elektrisch leitende Schicht (42), in dieser Reihenfolge, auf der zweiten Hauptoberfläche des Halbleitersubstrats in dem Bereich (112) des zweiten Leitfähigkeitstyps angeordnet sind.

3. Solarzelle nach Anspruch 1 oder 2, wobei
unter den in einem zentralen Bereich (XC) der zweiten Richtung angeordneten Bereichen des ersten Leitfähigkeitstyps ein Verhältnis des Bereichs (433, 434) des ersten Leitfähigkeitstyps, der mit dem seitlichen Peripherierandbereich (416a) des ersten Leitfähigkeitstyps verbunden ist, 30 % oder weniger beträgt,
wobei der zentrale Bereich (XC) der zweiten Richtung als ein Bereich definiert ist, über den sich ein leitfähiger Bereich (428a, 428b, 428c), der in dem Endabschnittsbereich (YE1, YE2) der ersten Richtung angeordnet ist und in Kontakt mit dem zentralen Bereich (YC) der ersten Richtung steht, in der zweiten Richtung erstreckt.

4. Solarzelle nach einem der Ansprüche 1 bis 3, wobei eine sich in der zweiten Richtung erstreckende Metallelektrode (428a, 428b, 428c) in einem leitfähigen Bereich (418a, 4718b, 418c) angeordnet ist, der in Kontakt mit einer Grenze des Endabschnittsbereichs (YE1, YE2) der ersten Richtung mit dem zentralen Bereich (YC) der ersten Richtung steht.

5. Solarzelle nach Anspruch 4, wobei die Metallelektrode (428b), die sich in der zweiten Richtung erstreckt, mit der Metallelektrode (421) verbunden ist, die in dem leitfähigen Bereich (411) angeordnet ist, der in dem zentralen Bereich (YC) der ersten Richtung angeordnet ist, und sich in der ersten Richtung erstreckt.

6. Solarzelle nach einem der Ansprüche 1 bis 5, wobei
die Metallelektrode (421, 422), die in dem leitfähigen Bereich angeordnet ist, der in dem zentralen Bereich (YC) der ersten Richtung angeordnet ist, einen Elektrodenabschnitt (460, 470) ohne Befestigung und einen Elektrodenabschnitt (461, 471) mit Verdrahtungsbefestigung aufweist, und
der Elektrodenabschnitt (460, 470) ohne Befestigung ein Bereich ist, der daran gehindert wird, mit einem Verdrahtungselement (51, 52) elektrisch verbunden zu werden, wenn das Verdrahtungselement (52, 51) auf dem Bereich angeordnet ist.

7. Solarzelle nach Anspruch 6, wobei der Elektrodenabschnitt (461, 471) mit Verdrahtungsbefestigung eine größere Elektrodenhöhe aufweist als der Elektrodenabschnitt (460, 470) ohne Befestigung.

8. Solarzelle nach Anspruch 6, wobei
die Metallelektrode (421, 422) mit einer Isolierschicht (90) in dem Elektrodenabschnitt ohne Befestigung (460, 470) bedeckt ist, und die Metallelektrode (421, 422) frei liegt, ohne mit einer Isolierschicht in dem Elektrodenabschnitt (461, 471) mit Verdrahtungsbefestigung bedeckt zu sein.

9. Solarzelle nach einem der Ansprüche 6 bis 8,
wobei die Metallelektrode (421), die in dem Bereich des ersten Leitfähigkeitstyps angeordnet ist, der in dem zentralen Bereich (YC) der ersten Richtung angeordnet ist, einen Elektrodenabschnitt (460) ohne Befestigung und einen Elektrodenabschnitt (461) mit Verdrahtungsbefestigung aufweist,
die Metallelektrode (422), die in dem Bereich des zweiten Leitfähigkeitstyps angeordnet ist, der in dem zentralen Bereich (YC) der ersten Richtung angeordnet ist, einen Elektrodenabschnitt (470) ohne Befestigung und einen Elektrodenabschnitt (471) mit Verdrahtungsbefestigung aufweist,
Elektrodenabschnitte (461) mit Verdrahtungsbefestigung von Metallelektroden (421) auf mehreren ersten Bereichen des ersten Leitfähigkeitstyps nebeneinander entlang der zweiten Richtung vorhanden sind, und
Elektrodenabschnitte (471) mit Verdrahtungsbefestigung von Metallelektroden (422) auf mehreren Bereichen des zweiten Leitfähigkeitstyps nebeneinander entlang der zweiten Richtung vorhanden sind.

10. Solarzellenmodul, das mehrere Solarzellen nach einem der Ansprüche 1 bis 9 umfasst, wobei die Solarzellen durch ein Verdrahtungselement verbunden sind.

11. Solarzellenmodul mit mehreren Solarzellen nach einem der Ansprüche 6 bis 9, wobei
jede der Solarzellen (401) elektrisch mit Verdrahtungselementen (51, 52) verbunden ist,
der Elektrodenabschnitt (461) mit Verdrahtungsbefestigung der in dem Bereich des ersten Leitfähigkeitstyps angeordneten Metallelektrode (421) elektrisch mit einem ersten Verdrahtungselement (51) verbunden ist, und
der Elektrodenabschnitt (471) mit Verdrahtungsbefestigung der im Bereich des zweiten Leitfähigkeitstyps angeordneten Metallelektrode (422) mit einem zweiten Verdrahtungselement (52) elektrisch verbunden ist.

## Revendications

1. Cellule solaire (400) comprenant un substrat semi-conducteur de forme rectangulaire (10) ayant une première surface principale et une deuxième surface principale, la deuxième surface principale incluant des régions d'un premier type de conductivité et des régions d'un deuxième type de conductivité, dans laquelle
une électrode métallique est disposée sur la deuxième surface principale, et aucune électrode métallique n'est disposée sur la première surface principale,
les régions du premier type de conductivité incluent une couche de semi-conducteur du premier type de conductivité, et les régions du deuxième type de conductivité incluent une couche de semi-conducteur du deuxième type de conductivité, ayant un type de conductivité différent de celui de la couche de semi-conducteur du premier type de conductivité,
une région de partie d'extrémité dans une première direction (YE1, YE2) est présente au niveau de chacune des deux parties d'extrémité du substrat semi-conducteur dans une première direction, et une région centrale dans une première direction (YC) est présente entre les deux régions de partie d'extrémité dans une première direction (YE1, YE2) avec, dans la région centrale dans la première direction (YC),
- des régions du premier type de conductivité (433, 411, 434) ayant une forme de bande s'étendant dans la première direction et des régions du deuxième type de conductivité (436, 412, 437) ayant une forme de bande s'étendant dans la première direction, disposées en alternance le long d'une deuxième direction,
dans laquelle, dans chacune des régions de partie d'extrémité dans la première direction (YE1, YE2), une région du premier type de conductivité latérale de bord périphérique (416a), une région du deuxième type de conductivité latérale périphérique extérieure (417a, 417b, 417c) et une région du premier type de conductivité (418a, 418b, 418c), ayant chacune une forme de bande s'étendant dans la deuxième direction, sont disposées dans cet ordre le long de la première direction à partir de la partie d'extrémité du substrat semi-conducteur,
**caractérisée en ce que**
au moins une région du premier type de conductivité (433, 434) s'étend dans la première direction au-delà des régions de partie d'extrémité dans la première direction (YE1, YE2) à partir de la région centrale dans la première direction (YC), et est connectée à la région du premier type de conductivité latérale de bord périphérique (416a), et
la région du deuxième type de conductivité latérale périphérique extérieure, qui est disposée adjacente à la région du premier type de conductivité latérale de bord périphérique (416a), est divisée en une pluralité de régions (417a, 417b, 417c) le long de la deuxième direction par l'au moins une région du premier type de conductivité (433, 434) qui est connectée à la région du premier type de conductivité latérale de bord périphérique (416a).

2. Cellule solaire selon la revendication 1, dans laquelle, dans la région centrale dans la première direction (YC), une couche de semi-conducteur intrinsèque (31), la couche de semi-conducteur du premier type de conductivité (11) et une couche électriquement conductrice transparente (41) sont disposées dans cet ordre sur la deuxième surface principale du substrat semi-conducteur dans la région du premier type de conductivité (111), et une couche de semi-conducteur intrinsèque (32), la couche de semi-conducteur du deuxième type de conductivité (12) et une couche électriquement conductrice transparente (42) sont disposées dans cet ordre sur la deuxième surface principale du substrat semi-conducteur dans la région du deuxième type de conductivité (112).

3. Cellule solaire selon la revendication 1 ou 2, dans laquelle
parmi les régions du premier type de conductivité disposées dans une région centrale dans la deuxième direction (XC), la proportion de la région du premier type de conductivité (433, 434) qui est connectée à la région du premier type de conductivité latérale de bord périphérique (416a) est de 30 % ou moins,
où la région centrale dans la deuxième région (XC) est définie comme une plage sur laquelle une région du type à conductivité (428a, 428b, 428c) agencée dans la région de partie d'extrémité dans la première direction (YE1, YE2) et en contact avec la région centrale dans la première direction (YC) s'étend dans la deuxième direction.

4. Cellule solaire selon l'une quelconque des revendications 1 à 3, dans laquelle une électrode métallique (428a, 428b, 428c) s'étendant dans la deuxième direction est disposée dans une région du type à conductivité (418a, 4718b, 418c) agencée en contact avec une limite de la région de partie d'extrémité dans la première direction (YE1, YE2) avec la région centrale dans la première direction (YC).

5. Cellule solaire selon la revendication 4, dans laquelle l'électrode métallique (428b) s'étendant dans la deuxième direction est connectée à l'électrode métallique (421) qui est disposée dans la région du type à conductivité (411) agencée dans la région centrale dans la première direction (YC), et s'étend dans la première direction.

6. Cellule solaire selon l'une quelconque des revendications 1 à 5, dans laquelle
l'électrode métallique (421, 422) disposée dans la région du type à conductivité agencée dans la région centrale dans la première direction (YC) a une section d'électrode sans montage (460, 470) et une section d'électrode de montage par câblage (461, 471), et
la section sans montage d'électrode (460, 470) est une région qui est empêchée d'être connectée électriquement à un élément de câblage (51, 52) quand l'élément de câblage (52, 51) est disposé sur la région.

7. Cellule solaire selon la revendication 6, dans laquelle la section d'électrode de montage par câblage (461, 471) a une hauteur d'électrode supérieure à la hauteur d'électrode de la section d'électrode sans montage (460, 470).

8. Cellule solaire selon la revendication 6, dans laquelle l'électrode métallique (421, 422) est recouverte d'une couche isolante (90) dans la section d'électrode sans montage (460, 470), et l'électrode métallique (421, 422) est exposée sans être recouverte d'une couche isolante dans la section d'électrode de montage par câblage (461, 471).

9. Cellule solaire selon l'une quelconque des revendications 6 à 8, dans laquelle
l'électrode métallique (421) disposée dans la région du premier type de conductivité agencée dans la région centrale dans la première direction (YC) a une section d'électrode sans montage (460) et une section d'électrode de montage par câblage (461),
l'électrode métallique (422) disposée dans la région du deuxième type de conductivité agencée dans la région centrale dans la première direction (YC) a une section d'électrode sans montage (470) et une section d'électrode de montage par câblage (471),
les sections d'électrode de montage par câblage (461) d'électrodes métalliques (421) sur une pluralité de régions du premier type de conductivité sont présentes côte à côte le long de la deuxième direction, et
les sections d'électrode de montage par câblage (471) d'électrodes métalliques (422) sur une pluralité de régions du deuxième type de conductivité sont présentes côte à côte le long de la deuxième direction.

10. Module de cellules solaires comprenant une pluralité des cellules solaires selon l'une quelconque des revendications 1 à 9, les cellules solaires étant connectées par l'intermédiaire d'un élément de câblage.

11. Module de cellules solaires comprenant une pluralité des cellules solaires selon l'une quelconque des revendications 6 à 9, dans lequel
chacune des cellules solaires (401) est connectée électriquement à des éléments de câblage (51, 52),
la section d'électrode de montage par câblage (461) de l'électrode métallique (421) agencée dans la région du premier type de conductivité est connectée électriquement à un premier élément de câblage (51), et
la section d'électrode de montage par câblage (471) de l'électrode métallique (422) agencée dans la région du deuxième type de conductivité est connectée électriquement à un deuxième élément de câblage (52).
